# EUROPEAN PATENT SPECIFICATION

(11) **EP 0 272 799 B1**
(45) Date of publication and mention of the grant of the patent: **10.02.1993**
(21) Application number: 87310277.6
(22) Date of filing: 20.11.1987
(51) Int. Cl.: H01L 21/00, H01L 21/268

(54) **Ablative etch resistant coating for laser personalization of integrated circuits**
Entfernbare ätzresistente Beschichtung für die Laserprogrammierung integrierter Schaltungen
Couche destructurable et résistant à la gravure pour la personnalisation par laser de circuits intégrés

(30) Priority: 26.11.1986 IL 80790; 10.03.1987 IL 81850
(43) Date of publication of application: 29.06.1988
(73) Proprietor: QUICK TECHNOLOGIES LTD., Haifa 31000 (IL)
(72) Inventor: Janai, Meir Israel, Haifa (IL); Orbach, Zvi, Haifa (IL)
(74) Representative: Collier, Jeremy Austin Grey

(56) References cited:
- EP-A- 0 111 128
- GB-A- 2 170 649
- IBM TECHNICAL DISCLOSURE BULLETIN, vol. 27, no. 10A, March 1985, pages 5764-5765, New York, US; "Wet etching for line deletion and short repair on ceramic substrates"
- Idem
- ELECTRONIC DESIGN, vol. 32, no. 12, 14th June 1984, pages 107-114,116,118,120,122, Waseca, MN, Denville, NJ, US; D. BURSKY: "Semiconductor technology"
- JOURNAL OF APPLIED PHYSICS, vol. 57, no. 8, part 1, 15th April 1985, pages 2909-2914, American Institute of Physics, Woodbury, New York, US; B.J. GARRISON et al.: "Laser ablation of organic polymers: Microscopic models for photochemical and thermal processes"
- SOLID STATE TECHNOLOGY, June 1981, pages 73-87, New York, US; M.J. BOWDEN: "Forefront of research on resists"
- NUCLEAR INSTRUMENTS & METHODS IN PHYSICS RESEARCH, vols. 209/210, part I, May 1983, pages 79-86, North-Holland Publishing Co., Amsterdam, NL; I. ADESIDA: "Ion bombardment of resists"
- SOLID STATE TECHNOLOGY, vol. 26, no. 12, December 1983, pages 165-169, Port Washington, New York, US; T. McGRATH: "Applications of excimer lasers in microelectronics"
- IBM TECHNICAL DISCLOSURE BULLETIN, vol. 21, no. 12, May 1979, pages 4848-4851, New York, US; J.J. GAJDA et al.: "Selective conversion of films to facilitate delineation"
- APPLIED PHYSICS LETTERS, vol. 47, no. 4, 15th August 1985, pages 361-362, American Institute of Physics, Woodbury, New YOrk, US; C. FIORI et al.: "High resolution ultraviolet photoablation of SiOx films"

## Description

The present invention relates to fabrication of integrated circuits and more particularly to techniques associated with the fabrication of prototype integrated circuits.

In the fabrication of prototype integrated circuits a metal layer is selectively removed. This removal may be effected, for example, by laser machining or chemical etching techniques. Normally a protective insulative layer, such as phosphorous-doped glass or silicon nitride or both of them, is formed over the metal layer for mechanical protection as well as electrical insulation.

Prior art document EP-A-0 111 128 discloses a process for selectively removing portions of a resist layer by ablative photo decomposition. The decomposition is caused by the incidence of ultraviolet radiation of wavelengths less than 220 nm.

### SUMMARY OF THE INVENTION

The present invention seeks to provide a technique for fabrication of prototype integrated circuits from finished integrated circuit blanks whereby it is possible to selectively remove portions of the metal conductor at a plurality of metal layers in the finished integrated circuit blank.

There is thus provided in accordance with of the present invention a technique for fabrication of prototype integrated circuits comprising the steps of:
providing at least one metal layer on a substrate;
coating at least portions of said at least one metal layer with an etch resistant layer comprising As₂S₃, or amorphous silicon (a - Si) such as a-Si:H, a-SiₓO₁₋ₓ:H, a-SiₓN₁₋ₓ:H, a-SiₓO_{y}N_{1-x-y}:H
where x and y are greater than or equal to 0 and less than or equal to 1, which may be ablated at selected regions by laser radiation having a wavelength above 350 nm directed thereto;
ablating the etch resistant layer at selected regions by applying thereto YAG laser radiation at a wavelength above 350 nm; and removing, preferably by chemically etching, said at least one metal layer underlying said selected regions to define the desired electrical characteristics of the integrated circuit.

In accordance with a preferred embodiment of the present invention, prototype integrated circuits are fabricated by a technique comprising the steps of providing a metal layer on a substrate, coating the metal layer with an insulative layer and defining a multiplicity of discrete apertures in the insulative layer overlying exposed regions of the metal layer which potentially may be sought to be removed, coating at least the exposed regions with the etch resistant layer, removing the etch resistant layer of selected ones of the exposed regions, and chemically etching the exposed regions to define the desired electrical characteristics of the integrated circuit.

The step of insulative coating is preferably effected by first coating the entire area and then using a mask to define the locations of multiplicity of discrete apertures which are formed by etching techniques. The mask is formed to define a selected array of apertures corresponding to a pre-determined metal layer removal arrangement.

The apertures thus formed over the metal layer at discrete locations serve to define precisely the boundaries of the fused area, when the radiation beam is of larger dimensions than the aperture or is not precisely centered thereon. Accordingly requirements for high accuracy in registration of the radiation beam may be relaxed.

Additionally in accordance with a preferred embodiment of the present invention the pattern of apertures established over the metal layer may define a pre-determined pattern for subsequent laser machining.

The etchable regions are selectably defined by removing the etch resistant layer with the underlying metal using laser radiation.

Additionally, in accordance with an embodiment of the present invention, an anti-reflective coating may be formed over the etch-resistant layer in order to reduce the energy requirement of the laser radiation.

### BRIEF DESCRIPTION OF THE DRAWINGS

The present invention will be understood and appreciated more fully from the following detailed description, taken in conjunction with the drawings wherein
Fig. 1 is a cross-sectional illustration of a portion of a typical integrated circuit;
Fig. 2 is a cross-sectional illustration of a typical integrated circuit having apertures formed in insulating layers thereof;
Fig. 3 is a cross-sectional illustration of a typical integrated circuit having apertures formed in insulating layers thereof and coated with an etch-resistant coating and an anti-reflective coating thereover;
Fig. 4 is a cross-sectional illustration of the integrated circuit of Fig. 3 after laser removal of the etch-resistant coating from one of the above-selected apertures;
Fig. 5 is a cross-sectional illustration of the integrated circuit of Fig. 4 after chemical etching of the metal underlying the removed etch resistant coating;
Fig. 6 is a cross-sectional illustration of the integrated circuit of Fig. 4 after removal of the etch resistant coating;
Fig. 7 is a scanning electromicrograph of the surface of a typical integrated circuit formed with apertures in the insulating layer overlying the metal layer thereof.

### DETAILED DESCRIPTION OF PREFERRED EMBODIMENTS

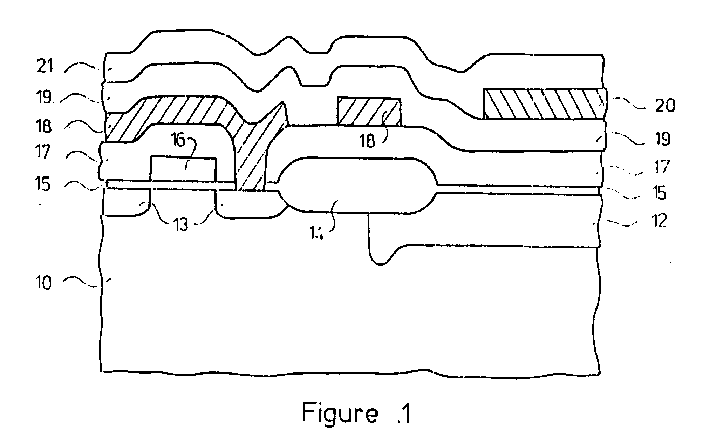

Reference is now made to Figs. 1 - 7, which illustrate a technique for manufacture of a prototype integrated circuit in accordance with a preferred embodiment of the present invention.

Fig. 1 illustrates in cross-section (not to scale) a portion of a typical integrated circuit comprising a substrate layer 10, typically formed of silicon or gallium arsenide. A plurality of ion implanted or diffusion doped layers 12 and 13 are disposed over substrate layer 10 and are covered by insulative layers 14 and 15, such as layers formed of silicon oxide, silicon nitride or polyimide. A conducting layer, such as a polysilicon gates 16, lies over layers 14 and 15. Gate 16, layer 15 and layer 14 are in turn covered by a further insulating layer 17, such as a layer formed of phosphorous-doped or undoped silicon oxide, silicon nitride or polyimide. Contact holes are formed in insulating layers 15 and 17 in order to provide electrical contact between layers 10, 12, 13 and 16 at required locations.

A conducting metal layer 18, such as a layer formed of aluminum, copper, gold, titanium, molybdenum, nickel, chrome, tungsten or combinations of the above, with or without silicon, is located over layer 17 and in local communication with a portion of diffusion layer 13. A further insulating layer 19, such as a layer formed of silicon oxide, silicon nitride or polyimide, overlies layers 17 and 18. An additional conducting metal layer 20 may be locally deposited over insulative layer 19. An insulative protective layer 21 overlies layers 19 and 20.

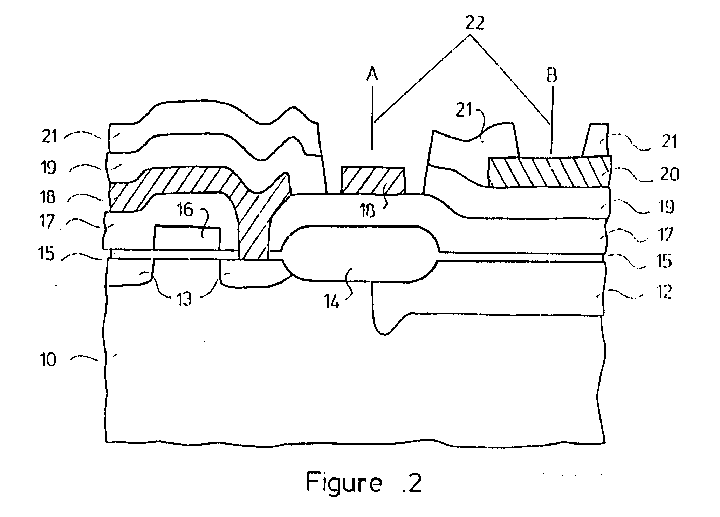

Referring now to Fig. 2, there is seen an integrated circuit of the same configuration as that illustrated in Fig. 1. It is seen that insulative layers 19 and 21 have been formed with discrete apertures 22, indicated by reference letters A ad B, so as to expose metal layers 18 and 20 respectively. In accordance with the present invention, apertures are defined in the insulative layer or layers at all locations at which it may be desired to remove metal thereunder.

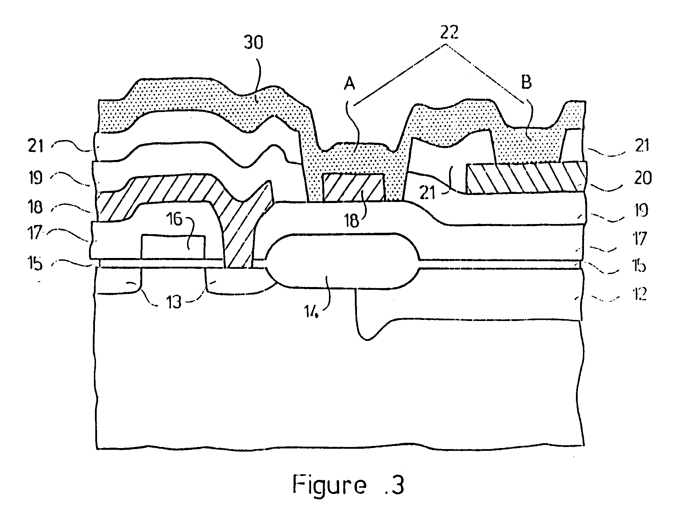

According to a preferred embodiment of the present invention, shown in Fig. 3, the configuration shown in Fig. 2 is further coated by an etch resistant volatile layer 30, typically formed of amorphous silicon (a - Si). Layer 30 is selected so as to absorb at least 10% of the energy of a pulsed laser such as a Q-switched YAG laser and is of typical thickness between 100 nm (1000 Angstrom) and 1.5 µm (15,000 Angstrom).

Preferably layer 30 is a-Si deposited by low-pressure, plasma-enhanced chemical vapor deposition or by sputtering at a temperature below 250 degrees Celsius so as to provide good step coverage without damaging the properties of metal layers 18 and 20 or the contact properties of the metal to semiconductor layers 10, 12, 13 and 16.

The chemical makeup of layer 30 includes As₂S₃, or amorphous silicon (a - Si) such as a-Si:H, a-SiₓO₁₋ₓ:H, a-SiₓN₁₋ₓ:H, a-SiₓO_{y}N_{1-x-y}:H
where x and y are greater than or equal to 0 and less than or equal to 1.

The a-Si layer may be phosphorous-doped or boron-doped with doping levels up to 10%. The hydrogen content may be up to 20%.

An anti-reflective coating, typically silicon nitride of a typical thickness of 66.5 nm (665 Angstrom), for laser radiation of wavelength 532 nm (5320 Angstrom), may be provided over the etch resistant layer 30 to reduce the energy required to define etchable windows therein.

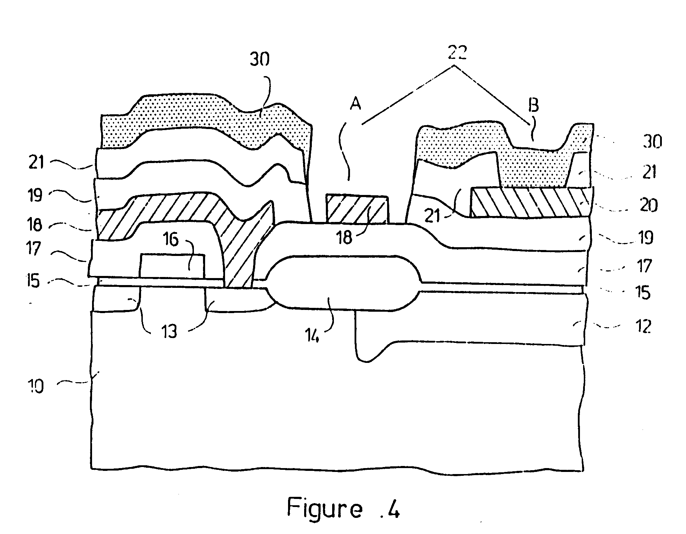

Referring now to Fig. 4, it is seen that subsequent to provision of an anti-reflective coating, the amorphous silicon layer 30 is blown away by the application of laser energy at selected locations over apertures 22, corresponding to locations where it is desired to remove the underlying metal. The laser radiation may be provided by a pulsed frequency doubled YAG laser with pulse energy typically between 0.2J/cm² and 10 J/cm².

Additionally in accordance with an embodiment of the present invention, an anti-reflective coating may be formed over the etch-resistant layer in order to reduce the energy requirements of the laser radiation.

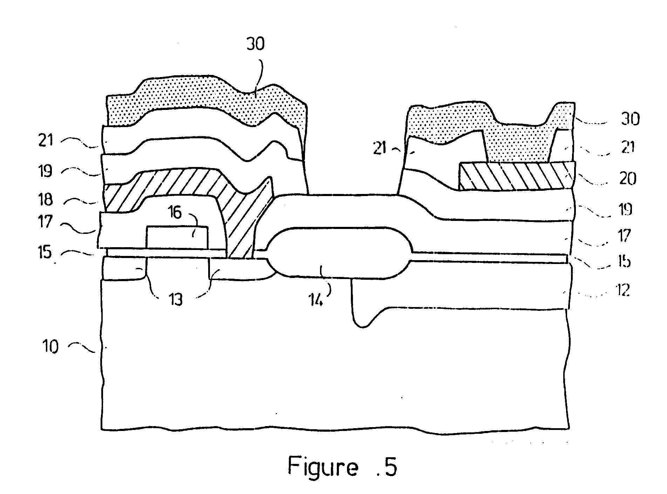

Following definition of etchable regions underlying the amorphous silicon layer 30 at the selected locations the integrated circuit blank is subjected to etching typically by an aluminum etchant, such as nitric acid combined with phosphoric acid and acetic acid, in solution for removal of the metal underlying those of apertures 22 having the etchable regions defined thereunder. Alternatively the metal removal may be achieved by plasma containing chlorine. It is appreciated that in any case layer 30 serves to protect all of the remaining surface of the integrated circuit, including those surfaces on which apertures 22 have been defined, against etching or metal removal by any other technique. Fig. 5 illustrates the partially completed integrated circuit after the above-described selected metal removal.

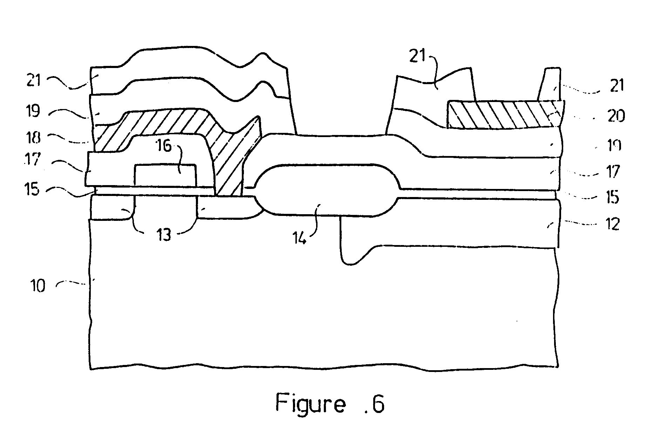

Following metal removal, the amorphous silicon layer 30 may be removed as by an amorphous silicon wet or dry etchant, such as a solution of HF - HNO₃ -CH₃COOH or XeF gas. This stage is illustrated in Fig. 6.

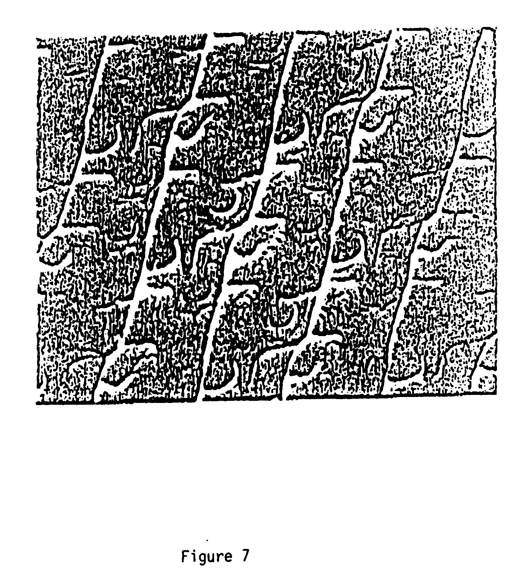

Fig. 7 is a photograph made by a scanning electron microscope, at a magnification of 2300X, illustrating the configuration shown in Fig. 2.

It will be appreciated by persons skilled in the art that the present invention is not limited by what has been particularly shown and described hereinabove. Rather the scope of the present invention is defined only by the claims which follow:

## Claims

1. A technique for fabrication of prototype integrated circuits comprising the steps of:
providing at least one metal layer on a substrate;
coating at least portions of said at least one metal layer with an etch resistant layer comprising As₂S₃, or amorphous silicon (a - Si) such as a-Si:H, a-SiₓO₁₋ₓ:H, a-SiₓN₁₋ₓ:H, a-SiₓO_{y}N_{1-x-y}:H
where x and y are greater than or equal to 0 and less than or equal to 1, which may be ablated at selected regions by laser radiation having a wavelength above 350 nm directed thereto;
ablating the etch resistant layer at selected regions by applying thereto YAG laser radiation at a wavelength above 350 nm; and
removing said at least one metal layer underlying said selected regions to define the desired electrical characteristics of the integrated circuit.

2. A technique according to claim 1 and also comprising the step of first coating the at least one metal layer with an insulative layer and using a mask to define the locations of multiplicity of discrete apertures in the insulative layer overlying exposed regions of the metal layer which potentially may be sought to be removed.

3. A technique according to claim 1 or 2 and also comprising the step of:
coating the etch resistant layer with an anti-reflective coating.

4. A technique according to claim 3 wherein said anti-reflective coating comprises silicon nitride.

5. A technique according to any of the preceding claims and also comprising the step of:
applying laser energy to the metal layer for fusing thereof, and wherein the apertures formed over the metal layer at discrete locations serve to define precisely the boundaries of the fused area, when the radiation beam is of larger dimensions than the aperture or is not precisely centered thereon.

6. A technique according to any of the preceding claims wherein the said metal layer is removed by chemical etching.

## Patentansprüche

1. Verfahren zur Herstellung von integrierten Prototypschaltungen, das die Schritte umfaßt: Vorsehen mindestens einer Metallschicht auf einem Substrat;
Beschichten von mindestens Teilen dieser mindestens einen Metallschicht mit einer Ätzresistschicht, umfassend As₂S₃ oder amorphes Silicium (a-Si), wie a-Si : H,
a-SiₓO₁₋ₓ : H, a-SiₓN₁₋ₓ : H, a-SiₓO_{y}N_{1-x-y} : H, worin x und y größer oder gleich 0 und kleiner oder gleich 1 sind, die an ausgewählten Bereichen durch darauf gerichtete Laserbestrahlung einer Wellenlänge großer 350 nm abgetragen werden kann;
Abtragen der Ätzresistschicht an ausgewählten Bereichen durch darauf Anwenden einer YAG-Laserstrahlung einer Wellenlänge größer 350 nm; und
Entfernen dieser mindestens einen Metallschicht, die sich unter diesen ausgewählten Bereichen erstreckt, um die gewünschten elektrischen Eigenschaften der integrierten Schaltung zu erhalten.

2. Verfahren nach Anspruch 1, das ferner den Schritt umfaßt, zunächst die mindestens eine Metallschicht mit einer Isolierschicht zu beschichten und eine Maske einzusetzen, zur Bestimmung der Orte einer Vielzahl diskreter Öffnungen in der Isolierschicht, welche ungeschützte Bereiche der Metallschicht, die eventuell entfernt werden wird, überdeckt.

3. Verfahren nach Anspruch 1 oder 2, das ferner den Schritt umfaßt, die Ätzresistschicht mit einer antireflektierenden Schicht zu beschichten.

4. Verfahren nach Anspruch 3, wobei die antireflektierende Schicht Siliciumnitrid aufweist.

5. Verfahren nach irgendeinem der vorhergehenden Ansprüche, das ferner den Schritt umfaßt: Anwenden von Laserenergie auf die Metallschicht zum Wegschmelzen, wobei die über der Metallschicht an diskreten Orten hergestellten Öffnungen dazu dienen, genau die Schmelzflächengrenzen zu bestimmen, wenn der Bestrahlungsstrahl größere Abmessungen besitzt als die Öffnung oder nicht genau darauf zentriert ist.

6. Verfahren nach irgendeinem der vorhergehenden Ansprüche, wobei die Metallschicht durch chemisches Ätzen entfernt wird.

## Revendications

1. Procédé de fabrication de circuits intégrés prototypes comportant les étapes consistant à :
déposer au moins une couche métallique sur un substrat ;
revêtir au moins des parties de ladite au moins une couche métallique d'une couche résistant à la gravure comportant As₂S₃, ou du silicium amorphe (a-Si) tel que du a-Si:H, a-SiₓO₁₋ₓ:H, a-SiₓN₁₋ₓ:H; a-SiₓO_{y}N_{1-x-y}:H où x et y sont supérieurs ou égaux à 0 et inférieurs ou égaux à 1, qui peut être éliminée en des régions choisies par un rayonnement laser possédant une longueur d'onde supérieure à 350 nm dirigé sur celle-ci ;
éliminer la couche résistant à la gravure en des régions choisies en y appliquant un rayonnement laser YAG de longueur d'onde supérieure à 350 nm ; et
éliminer ladite au moins une couche métallique sous-jacente auxdites régions choisies pour définir les caractéristiques électriques souhaitées du circuit intégré.

2. Procédé selon la revendication 1, comportant également l'étape consistant à revêtir en premier lieu la au moins une couche métallique d'une couche isolante et utiliser un masque pour définir les emplacements d'une pluralité d'ouvertures discrètes dans la couche isolante recouvrant des régions à nu de la couche métallique que, potentiellement, on peut souhaiter éliminer.

3. Procédé selon la revendication 1 ou 2, comportant également l'étape consistant à revêtir la couche résistant à la gravure d'un revêtement anti-réfléchissant.

4. Procédé selon la revendication 3, dans lequel ledit revêtement anti-réfléchissant est en nitrure de silicium.

5. Procédé selon l'une quelconque des revendications précédentes, comportant également l'étape consistant à appliquer une énergie laser à la couche métallique pour la fusion de celle-ci, et dans lequel les ouvertures pratiquées dans la couche de métal en des emplacements discrets servent à définir avec précision les limites de la zone fondue, lorsque le faisceau de rayonnement est de dimensions supérieures à l'ouverture ou n'est pas centré avec précision sur celle-ci.

6. Procédé selon l'une quelconque des revendications précédentes, dans lequel ladite couche métallique est éliminée par gravure chimique.
